# EUROPEAN PATENT SPECIFICATION

(11) **EP 4 633 350 B1**
(45) Date of publication and mention of the grant of the patent: **09.09.2026**
(21) Application number: 22967822.2
(22) Date of filing: 07.12.2022
(51) Int. Cl.: H10N 60/01, H10N 60/80, H10N 69/00

(54) **QUANTUM BIT DEVICE, METHOD OF MANUFACTURING QUANTUM BIT DEVICE, AND METHOD FOR MEASURING QUANTUM BIT DEVICE**
QUANTENBITVORRICHTUNG, VERFAHREN ZUR HERSTELLUNG EINER QUANTENBITVORRICHTUNG UND VERFAHREN ZUR MESSUNG EINER QUANTENBITVORRICHTUNG
DISPOSITIF À BIT QUANTIQUE, PROCÉDÉ DE FABRICATION D'UN DISPOSITIF À BIT QUANTIQUE ETPROCÉDÉ DE MESURE D'UN DISPOSITIF À BIT QUANTIQUE

(43) Date of publication of application: 15.10.2025
(73) Proprietor: FUJITSU LIMITED, Kawasaki-shi, Kanagawa 211-8588 (JP)
(72) Inventor: FUKUMORI, Taiga, Kawasaki-shi, Kanagawa 211-8588 (JP)
(74) Representative: Hoffmann Eitle
(86) International application number: PCT/JP2022/045089
(87) International publication number: WO 2024/121971

(56) References cited:
- WO-A1-2021/204897
- JP-A- 2011 058 852
- JP-A- 2021 103 510
- JP-A- 2021 504 964
- JP-A- 2021 524 198
- US-A1- 2021 384 896

## Description

### [Technical Field]

A certain aspect of the present embodiments relates to a quantum bit device, a method of manufacturing a quantum bit device, and a method of measuring a quantum bit device.

### [Background Art]

A quantum bit device is known in which a quantum bit and a signal wiring electrically connected to the quantum bit are provided on a substrate. For example, it is known that the signal wiring has a two-layer structure of a superconductor material (for example, Patent Literature 1, and Patent Literature 2), or has a two-layer structure of a superconductor layer and a normal metal layer (for example, Patent Literature 3). It is also known that a signal wiring is formed of a superconductor layer and an antiferromagnetic insulating layer covering the surface of the superconductor layer (for example, Patent Literature 4).

### [Citation List]

### [Patent Literature]

Patent Literature 1: Japanese National Publication of International Patent Application No. 2020-533804
Patent Literature 2: U.S. Laid-Open Patent Publication No. 2020/0012961
Patent Literature 3: Japanese Laid-Open Patent Publication No. 2009-302219
Patent Literature 4: Japanese Laid-Open Patent Publication No. 2011-44631

Further examples of the prior art can be found in WO 2021/204897 A1, JP 2021 504964 A, JP 2021 524198 A, JP 2011 058852 A, US 2021/384896 A1 or JP 2021 103510 A.

### [Summary of Invention]

### [Technical Problem]

In general, a quantum bit device measures characteristic of a signal wiring at a cryogenic temperature of several tens of milli-kelvin (mK). In this case, there are problems that it takes a long time to cool a temperature to the cryogenic temperature, and it is difficult to replace a measurement terminal in a cooling device.

Therefore, it is desired to measure the characteristic of the signal wiring under a temperature environment of a normal temperature. However, since the width of the signal wiring is narrow, it is difficult to measure the characteristic of the signal wiring by bringing the measurement terminal into direct contact with the signal wiring. In addition, even if the characteristic of the signal wiring are measured through the quantum bit, it is difficult to measure the characteristic of the signal wiring because a direct current (DC) resistance value of the quantum bit is as high as several thousand ohms at the normal temperature.

In one aspect, it is an object of the present disclosure to enable measurement of the characteristic of the signal wiring under the temperature environment of the normal temperature.

### [Solution to Problem]

According to one aspect, there is provided a quantum bit device including: a substrate; a quantum bit provided on the substrate; a signal wiring provided on the substrate and electrically connected to the quantum bit; and a semiconductor film provided to overlap a part of the signal wiring, the semiconductor film having a width larger than a width of the signal wiring.

According to one aspect, there is provided a method of manufacturing a quantum bit device including: forming a signal wiring on a substrate; forming a semiconductor film having a width larger than a width of the signal wiring, the semiconductor film overlapping a part of the signal wiring; and forming a quantum bit electrically connected to the signal wiring on the substrate.

According to one aspect, there is provided a method of measuring a quantum bit device, the quantum bit device including a quantum bit and a signal wiring electrically connected to the quantum bit on a substrate, and including a semiconductor film having a width larger than a width of the signal wiring, the semiconductor film overlapping a part of the signal wiring, the method comprising: bringing a measurement terminal into contact with the semiconductor film; and measuring a characteristic of the signal wiring.

### [Advantageous Effects of Invention]

As one aspect, it is possible to measure the characteristics of the signal wiring under a temperature environment of a normal temperature.

### [Brief Description of Drawings]

[FIG. 1] FIG. 1(a) is a plan view of a quantum bit device according to a first embodiment, and FIG. 1(b) is an enlarged plan view of a region in the vicinity of a resonator.
[FIG. 2] FIG. 2(a) is a plan view of a region in the vicinity of an end of a signal wiring of a quantum bit device according to the first embodiment, and FIG. 2(b) is a cross-sectional view taken along a line A-A in FIG. 2(a).
[FIG. 3] FIGs. 3(a) to 3(d) are cross-sectional views illustrating a method of manufacturing the quantum bit device according to the first embodiment (Part 1).
[FIG. 4] FIGSs 4(a) and 4(b) are cross-sectional views illustrating a method of manufacturing the quantum bit device according to the first embodiment (Part 2).
[FIG. 5] FIG. 5(a) is a cross-sectional view illustrating a method of measuring a direct current (DC) resistance of the signal wiring in the first embodiment, and FIG. 5(b) is a plan view illustrating a method of measuring a direct current (DC) resistance of the signal wiring in the first embodiment.
[FIG. 6] FIG. 6(a) is a cross-sectional view illustrating a method of measuring a high frequency characteristic of the signal wiring in the first embodiment, and FIG. 6(b) is a plan view illustrating a method of measuring a high frequency characteristic of the signal wiring in the first embodiment.
[FIG. 7] FIG. 7 is a schematic circuit diagram of the quantum bit device according to the first embodiment.
[FIG. 8] FIGs. 8(a) to 8(c) are diagrams illustrating simulation results of the resonance waveforms of the signal wiring in the first embodiment (Part 1).
[FIG. 9] FIGs. 9(a) and 9(b) are diagrams illustrating simulation results of the resonance waveforms of the signal wiring in the first embodiment (Part 2).
[FIG. 10] FIGs. 10(a) to 10(c) are diagrams illustrating simulation results of the resonance waveforms when resonance frequencies are made different in the signal wiring in the first embodiment.
[FIG. 11] FIGs. 11(a) to 11(d) are diagrams illustrating simulation results of TDR waveforms of the signal wiring in the first embodiment.
[FIG. 12] FIG. 12(a) is a plan view of a region in the vicinity of an end of a signal wiring of a quantum bit device according to a second embodiment, and FIG. 12(b) is a cross-sectional view taken along a line A-A in FIG. 12(a).
[FIG. 13] FIG. 13(a) is a cross-sectional view illustrating a method of measuring a DC resistance of the signal wiring according to the second embodiment, and FIG. 13(b) is a cross-sectional view illustrating a method of measuring a high frequency characteristic.
[FIG. 14] FIG. 14 is a cross-sectional view of a region in the vicinity of an end of a signal wiring of a quantum bit device according to a third embodiment.
[FIG. 15] FIGs. 15(a) to 15(c) are cross-sectional views illustrating a method of manufacturing the quantum bit device according to the third embodiment.
[FIG. 16] FIG. 16 is a cross-sectional view of a region in the vicinity of an end of a signal wiring of a quantum bit device according to a fourth embodiment.
[FIG. 17] FIG. 17(a) is a plan view of a quantum bit device according to a fifth embodiment, and FIG. 17(b) is an enlarged plan view of a region in the vicinity of a resonator and a bandpass filter.
[FIG. 18] FIG. 18(a) is a plan view of a region in the vicinity of an end of a signal wiring of the quantum bit device according to the fifth embodiment, and FIG. 18(b) is a cross-sectional view taken along a line A-A in FIG. 18(a).

### [Description of Embodiments]

Hereinafter, embodiments of the present disclosure will be described with reference to the drawings.

### [First Embodiment]

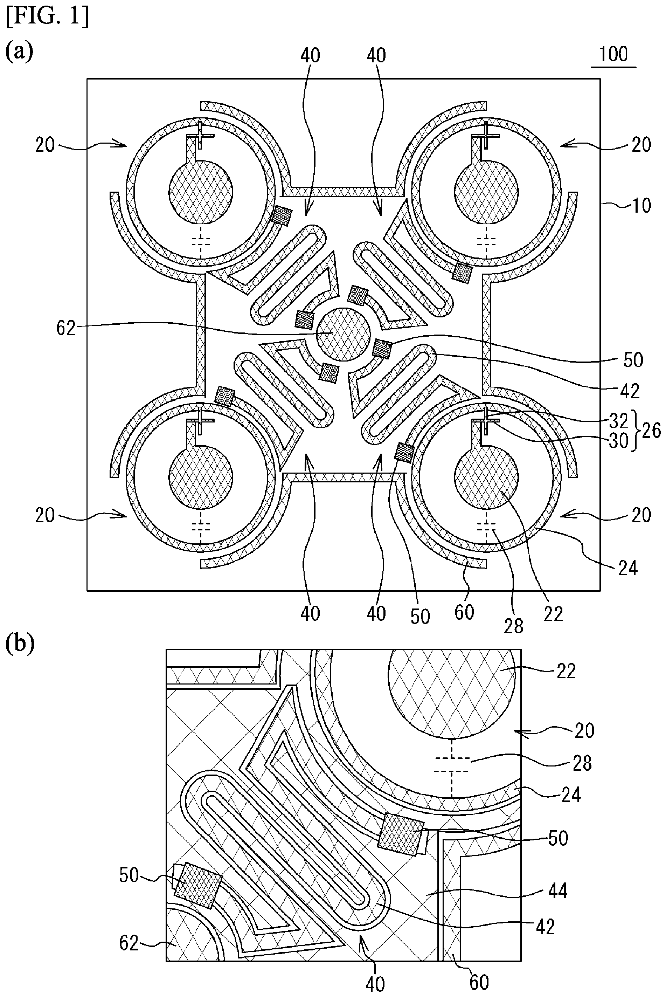

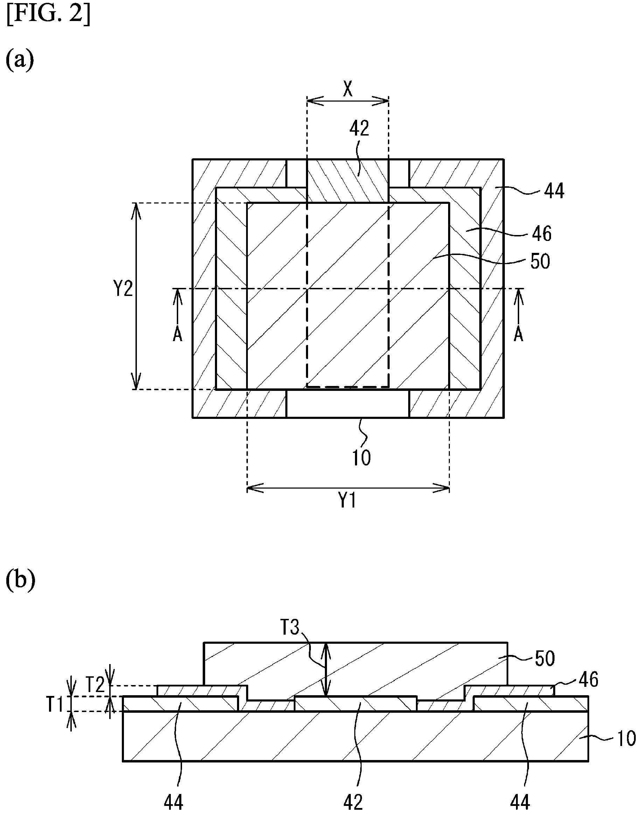

FIG. 1(a) is a plan view of a quantum bit device 100 according to a first embodiment, and FIG. 1(b) is an enlarged plan view of a region in the vicinity of a resonator 40. In FIGs. 1(a) and 1(b), a superconductor film and a semiconductor film provided on a substrate 10 are hatched for the sake of clarity of the drawing. For the sake of clarity of the drawing, a ground layer 44 illustrated in FIG. 1(b) is omitted in FIG. 1(a), and an insulating film 46 illustrated in FIGs. 2(a) and 2(b) is omitted in FIGs. 1(a) and 1(b).

As illustrated in FIGs. 1(a) and 1(b), the quantum bit device 100 according to the first embodiment includes a plurality of quantum bits 20, a plurality of resonators 40, a plurality of coupling wirings 60, and a read terminal 62 on the substrate 10. The quantum bit device 100 is used in a quantum computer that operates in a superconducting state at the cryogenic temperature of, for example, several tens of milli-kelvin (mK).

The plurality of resonators 40 are electrostatically coupled to the plurality of quantum bits 20, respectively. The plurality of resonators 40 are electrostatically coupled to the single read terminal 62. The resonator 40 interacts with the quantum bit 20 to read out the state of the quantum bit 20. The read state of the quantum bit 20 is taken out to the outside via the read terminal 62. The resonator 40 is, for example, an LC resonator which is a lumped constant circuit, a λ/2 resonator which is a distributed constant circuit, a λ/4 resonator which is a distributed constant circuit, or the like. The coupling wiring 60 is a wiring which is electrostatically coupled to the quantum bits 20 and couples between the adjacent quantum bits 20. The connection between the quantum bit 20 and the resonator 40, the connection between the resonator 40 and the read terminal 62, and the connection between the quantum bit 20 and the coupling wiring 60 are connection at high frequency.

The quantum bit 20 includes a Josephson junction element 26 which is joined between a central electrode 22 and an outer peripheral electrode 24, and a capacitor 28 which is formed by the central electrode 22 and the outer peripheral electrode 24 facing each other. The Josephson junction element 26 is connected between the central electrode 22 and the outer peripheral electrode 24 by connecting a superconductor film 30 to the central electrode 22 and connecting a superconductor film 32 to the outer peripheral electrode 24. In a region where the superconductor film 30 and the superconductor film 32 intersect each other, an insulating film (not illustrated) is provided between the superconductor film 30 and the superconductor film 32.

The resonator 40 includes a coplanar line having a meander structure in which a signal wiring 42 is interposed between the ground layers 44. A high frequency signal for reading in, for example, a gigahertz band (for example, 2 GHz to 10 GHz) is propagated to the signal wiring 42. A semiconductor film 50 is provided so as to overlap both ends of the signal wiring 42. The semiconductor film 50 is not provided at a portion other than both ends of the signal wiring 42. The semiconductor film 50 is provided in contact with both ends of the signal wiring 42. The semiconductor film 50 is provided away from the quantum bit 20 and is not in contact with the outer peripheral electrode 24 and the like constituting the quantum bit 20. Although FIG. 1(b) illustrates an example in which the ground layer 44 is also provided between the quantum bit 20 and the resonator 40, there may be no ground layer 44 between the quantum bit 20 and the resonator 40.

FIG. 2(a) is a plan view of a region in the vicinity of an end of the signal wiring 42 of the quantum bit device 100 according to the first embodiment, and FIG. 2(b) is a cross-sectional view taken along a line A-A in FIG. 2(a). In FIG. 2(a), for the sake of clarity of the drawing, hatching is provided on the signal wiring 42, the ground layer 44, the insulating film 46, and the semiconductor film 50. As illustrated in FIGs. 2(a) and 2(b), the semiconductor film 50 has a width larger than the width of the signal wiring 42 and is provided to cover the entire portion of the signal wiring 42 in a width direction. The width X of the signal wiring 42 is, for example, 10 µ m to 30 µ m. The semiconductor film 50 has, for example, a rectangular shape in plan view. The width Y1 of the signal wiring 42 in the width direction and the width Y2 of the signal wiring 42 in a direction perpendicular to the width direction are larger than the width of the signal wiring 42, and are 50 µm to 500 µm. As described above, the semiconductor film 50 has an outer shape larger than the width of the signal wiring 42.

The insulating film 46 is provided from on the ground layer 44 to a gap between the signal wiring 42 and the ground layer 44, with the upper surface of the signal wiring 42 exposed without being covered. The semiconductor film 50 is in contact with the upper surface of the signal wiring 42 and is provided from on the signal wiring 42 to on the insulating film 46. Therefore, the semiconductor film 50 is not in contact with the ground layer 44. The signal wiring 42 and the ground layer 44 have the same thickness T1, and the thickness T1 is, for example, 0.01 µm to 20 µm. The thickness T2 of the insulating film 46 is, for example, 1 µm to 20 µm. The thickness T3 of the semiconductor film 50 is, for example, 5 µm to 30 µm.

The substrate 10 is an insulating substrate such as a silicon substrate or a sapphire substrate. The signal wiring 42 and the ground layer 44 are formed of a superconducting material such as aluminum (Al), titanium nitride (TiN), niobium (Nb), or tantalum (Ta). The insulating film 46 is formed of a resin material or an inorganic insulating material, for example, a solder resist. The semiconductor film 50 is formed of an insulating semiconductor material having an electrical resistivity of 10⁴ Ω · m or more at a cryogenic temperature of 20 milli-kelvin (mK). For example, the semiconducting film 50 is formed of an oxide semiconductor such as amorphous silicon, indium oxide (In₂O₃), titanium dioxide (TiO₂), or zinc oxide (ZnO), a III-V group compound semiconductor such as gallium arsenide (GaAs) or indium phosphide (InP), or a II-VI group compound semiconductor such as cadmium telluride (CdTe) or cadmium sulfide (CdS). The semiconductor film 50 may be doped with a material such as phosphorus (P) and boron (B).

### [Manufacturing Method]

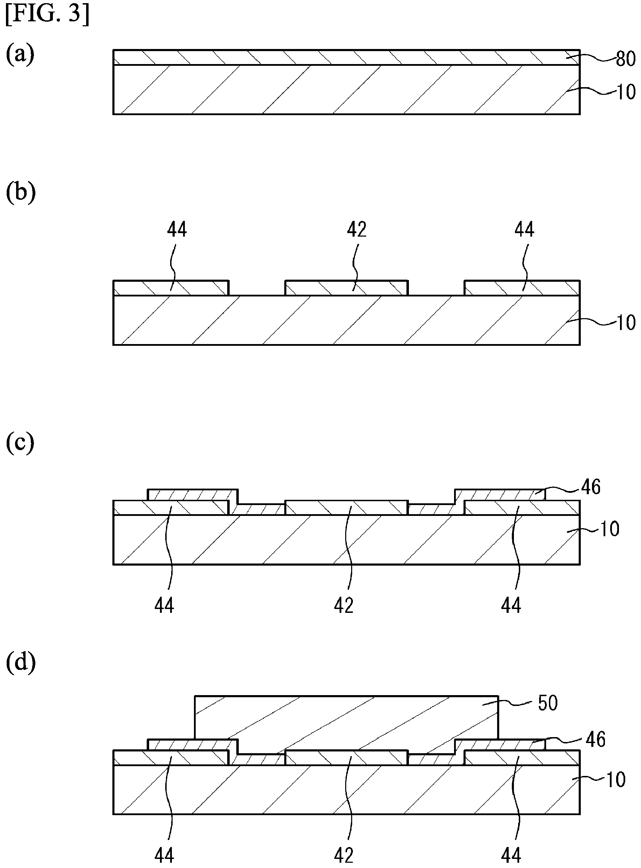

FIGs. 3(a) to 3(d) and FIGSs 4(a) and 4(b) are cross-sectional views illustrating a method of manufacturing the quantum bit device 100 according to the first embodiment. As illustrated in FIG. 3(a), a superconductor film 80 is formed on the substrate 10 by, for example, a sputtering method or a vapor deposition method.

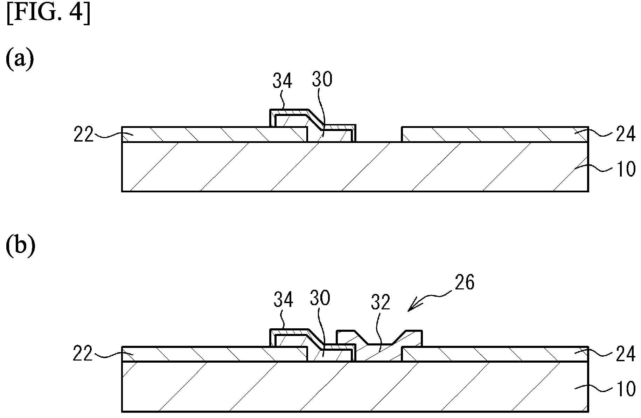

As illustrated in FIG. 3(b), the superconductor film 80 is patterned by using, for example, a photolithography method and an etching method. Thus, the signal wiring 42 and the ground layer 44 constituting the resonator 40 are formed. As illustrated in FIG. 4(a), the central electrode 22 and the outer peripheral electrode 24 are also formed. Although not illustrated, the coupling wiring 60 and the read terminal 62 are also formed.

As illustrated in FIG. 3(c), the insulating film 46 is formed on the substrate 10 by, for example, a printing method, the sputtering method, the vapor deposition method, or a CVD (Chemical Vapor Deposition) method. Thereafter, the insulating film 46 is patterned by, for example, the photolithography method and the etching method. As a result, the insulating film 46 is formed from on the ground layer 44 to the gap between the ground layer 44 and the signal wiring 42, and exposes the upper surface of the signal wiring 42.

As illustrated in FIG. 3(d), the semiconductor film 50 is formed above the substrate 10 by, for example, the sputtering method, the vapor deposition method, or the CVD method. Thereafter, the semiconductor film 50 is patterned by using, for example, the photolithography method and the etching method. Thus, semiconductor film 50 is formed on both ends of the signal wiring 42, and the semiconductor film 50 is in contact with the upper surface of the signal wiring 42 and covers the signal wiring 42. The semiconductor film 50 is formed from on the signal wiring 42 to on the insulating film 46.

As illustrated in FIG. 4(a), the superconductor film 30 connected to the central electrode 22 is formed. The superconductor film 30 is formed by, for example, an oblique evaporation method and a lift-off method. Thereafter, the surface of the superconductor film 30 is oxidized to form an insulating film 34 on the surface of the superconductor film 30.

As illustrated in FIG. 4(b), the superconductor film 32 connected to the outer peripheral electrode 24 is formed. The superconductor film 32 is formed by, for example, the oblique evaporation method and the lift-off method. Thus, the Josephson junction element 26 having a Josephson junction portion, which is a region where the superconductor film 30 overlaps the superconductor film 32 via the insulating film 34 therebetween, is formed.

### [Measurement Method]

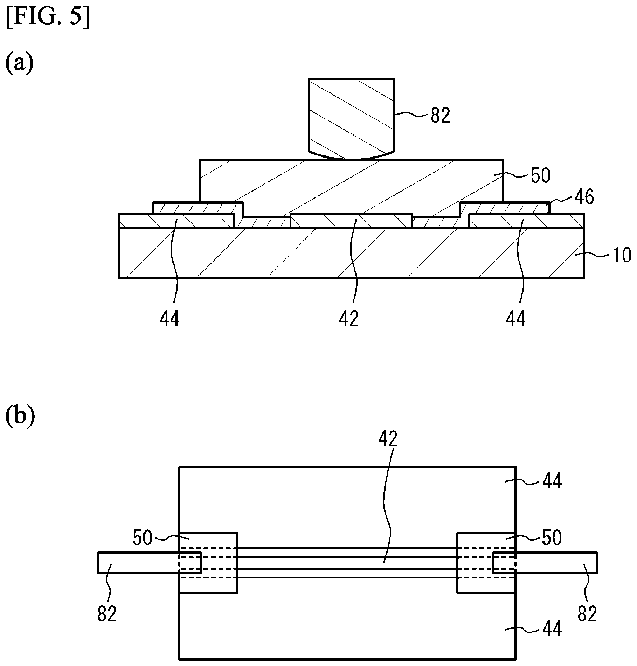

FIG. 5(a) is a cross-sectional view illustrating a method of measuring a direct current (DC) resistance of the signal wiring 42 in the first embodiment. FIG. 5(b) is a plan view illustrating a method of measuring a direct current (DC) resistance of the signal wiring 42 in the first embodiment. In FIG. 5(b), for the sake of clarity of the drawing, the signal wiring 42 is illustrated by a straight line, and the insulating film 46 is omitted from the drawing. The DC resistance may be measured before or after the Josephson junction element 26 is formed under an environment of the normal temperature (for example, 20 °C ± 15 °C). As illustrated in FIGs. 5(a) and 5(b), the DC resistance of the signal wiring 42 is measured by bringing measurement terminals 82 into contact with the semiconductor films 50 provided on the ends of the signal wiring 42. As a measuring device for measuring the DC resistance, for example, a semiconductor parameter is used. For example, if disconnection occurs in the signal wiring 42, the DC resistance value becomes infinite, and if short-circuit occurs in the signal wiring 42, the DC resistance value becomes a value in which the resistance value of the semiconductor film 50 becomes dominant.

As an example, assume that the width X of the signal wiring 42 is 30 µm, the widths Y1 and Y2 of the semiconductor film 50 are 100 µm, the thickness T3 of the semiconductor film 50 is 10 µm, and the conductivity of the semiconductor film 50 is 20 S/m (see FIGs. 2(a) and 2(b)). In this case, the resistance R of the semiconductor film 50 with respect to the current flowing between the measurement terminal 82 and the signal wiring 42 is obtained by R = (10 × 10⁻⁶) / 20 × (100 × 10⁻⁶) × (50 × 10⁻⁶), and is about 100 Ω. In the above equation, the value "(10 × 10⁻⁶)" in the above-mentioned formula is the thickness of the semiconductor film 50. The value "20" in the above-mentioned formula denotes the conductivity of the semiconductor film 50. The value "(100 × 10⁻⁶)" in the above-mentioned formula is the length of the overlap between the signal wiring 42 and the semiconductor film 50. The value "(50 × 10⁻⁶)" in the above-mentioned formula is a rough width of the current collected in the signal wiring 42 having a width of 30 µm.

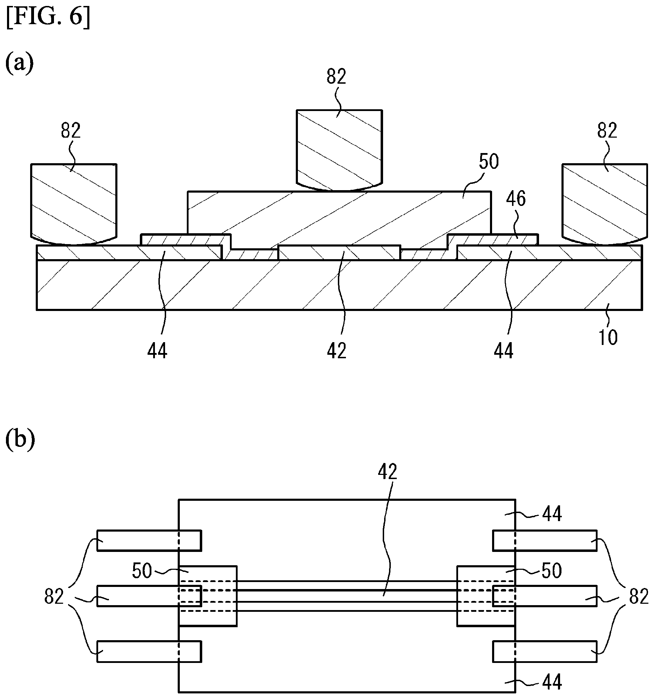

FIG. 6(a) is a cross-sectional view illustrating a method of measuring a high frequency characteristic of the signal wiring 42 in the first embodiment. FIG. 6(b) is a plan view illustrating a method of measuring a high frequency characteristic of the signal wiring 42 in the first embodiment. In FIG. 6(b), for the sake of clarity of the drawing, the signal wiring 42 is illustrated by straight lines, and the insulating film 46 is not illustrated. The measurement of the high frequency characteristic may be performed in the same manner as the measurement of the DC resistance, under the environment of the normal temperature (for example, 20 °C ± 15 °C), before or after the Josephson junction element 26 is formed. As illustrated in FIGs. 6(a) and 6(b), the high frequency characteristic of the signal wiring 42 are measured by bring the measurement terminals 82 into contact with the semiconductor films 50 provided on the ends of the signal wiring 42 and the ground layers 44 on both sides of each of the semiconductor films 50. In the measurement of the high frequency characteristic, the measurement terminals 82 may be brought into contact with the semiconductor films 50 and the ground layers 44 on both sides of each of the semiconductor films 50 at both ends of the signal wiring 42, or may be brought into contact with the semiconductor film 50 and the ground layers 44 on both sides of the semiconductor film 50 at only one end of the signal wiring 42. Examples of the high frequency characteristic include a resonance waveform and a TDR (Time Domain Reflectometry). As the high frequency characteristic, for example, a resonance waveform or a TDR (Time Domain Reflectometry) waveform is measured. For example, a vector network analyzer is used as a measurement device for measuring the resonance waveform. For example, a TDR oscilloscope or the TDR transform of a vector network analyzer is used as a measurement device for measuring the TDR waveform.

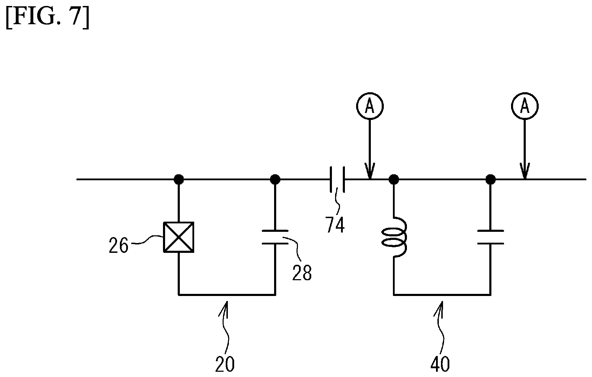

FIG. 7 is a schematic circuit diagram of the quantum bit device 100 according to the first embodiment. As illustrated in FIG. 7, the quantum bit 20 and the resonator 40 are coupled to each other via a capacitor 74. The measurement of the characteristic of the signal wiring 42 by bringing the measurement terminals 82 into contact with the semiconductor films 50 provided at the ends of the signal wiring 42 corresponds to the measurement of the characteristic of the signal wiring 42 by bringing the measurement terminals 82 into contact with portions indicated by arrows A. Therefore, the characteristic of the signal wiring 42 can be measured without being affected by the quantum bit 20 coupled via the capacitor 74.

For example, when the resonator 40 is a resonator of a distributed constant circuit, the signal wiring 42 becomes thin and long, and therefore the DC resistance of the signal wiring 42 increases and may reach, for example, several hundred ohms. In such a case, it is desired to measure the DC resistance as the characteristic of the signal wiring 42. When the resonator 40 is a resonator of a lumped constant circuit, the signal wiring 42 is short, and therefore the DC resistance decreases. In such a case, it is desired to measure the high frequency characteristic such as a resonance waveform and/or a TDR waveform as the characteristic of the signal wiring 42.

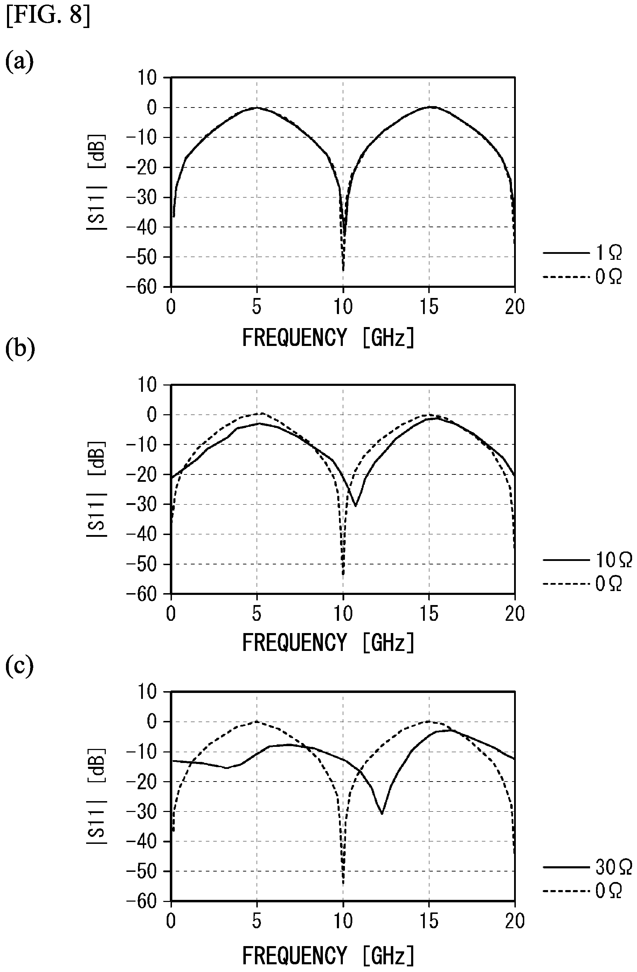

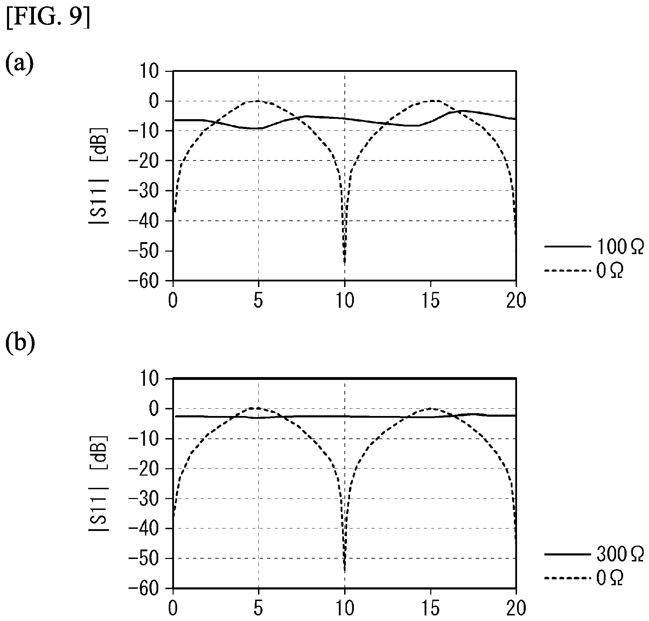

FIGs. 8(a) to 9(b) are diagrams illustrating simulation results of resonance waveforms of the signal wiring 42 in the first embodiment. In FIGs. 8(a) to 9(b), a horizontal axis represents the frequency in GHz units, and a vertical axis represents the reflection characteristic |S11| in dB units. In FIGs. 8(a) to 9(b), waveforms in the case where the total DC resistance value of the signal wiring 42 and the semiconductor films 50 provided at both ends of the signal wiring 42 is 0 Ω is indicated by dotted lines, and waveforms in the case where the total DC resistance value of the signal wiring 42 and the semiconductor films 50 provided at both ends of the signal wiring 42 is 1 Ω, 10 Ω, 30 Ω, 100 Ω, and 300 Ω are indicated by solid lines. The resistance value of the semiconductor film 50 was determined as described in paragraph 0028. The simulation conditions are as follows:
Substrate 10: Silicon Substrate
Signal line 42 and ground layer 44: aluminum layer
Insulating Film 46: Solder Resist
Semiconductor Film 50: Amorphous Silicon
Average relative dielectric constant of air and silicon substrate: 6.25
Length of signal wiring 42:6 mm
Width X of signal wiring 42:0.02 mm
Resonance frequency: 10 GHz

As illustrated in FIGs. 8(a) to 9(b), the resonance was confirmed when the total DC resistance value of the signal wiring 42 and the semiconductor film 50 was 30 Ω or less, but the resonance was not confirmed when the total DC resistance value of the signal wiring 42 and the semiconductor film 50 was 100 Ω or more. From this result, it is understood that resonance can be confirmed when the total DC resistance value of the signal wiring 42 and the semiconductor film 50 is less than 100 Ω, and preferably 30 Ω or less.

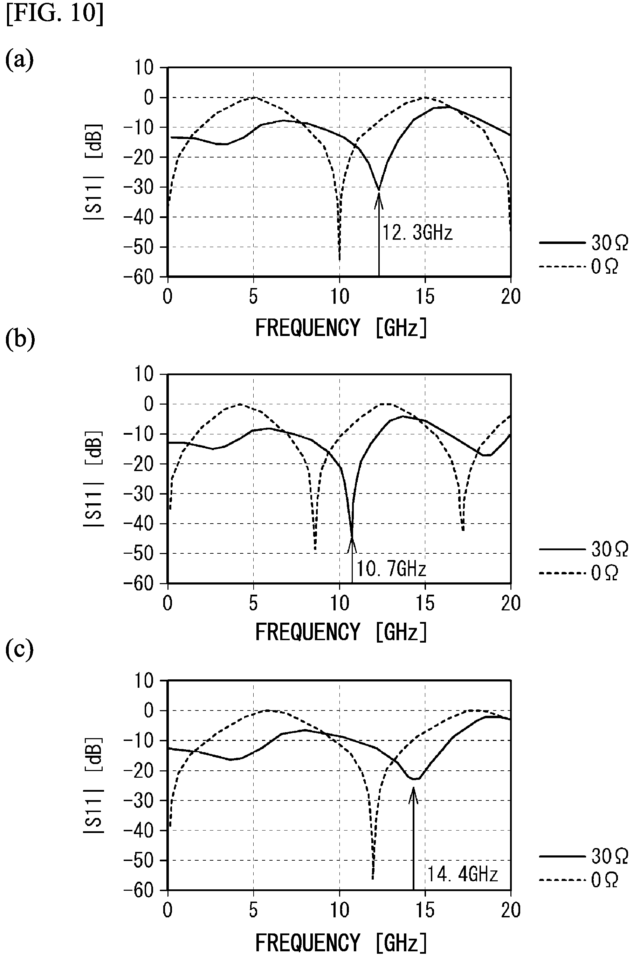

FIGs. 10(a) to 10(c) are diagrams illustrating simulation results of resonance waveforms when resonance frequencies are made different in the signal wiring 42 in the first embodiment. In FIGs. 10(a) to 10(c), a horizontal axis represents the frequency in GHz units, and a vertical axis represents the reflection characteristic |S11| in dB units. In FIGs. 10(a) to 10(c), waveforms when the total DC resistance value of the signal wiring 42 and the semiconductor film 50 is 0 Ω are indicated by dotted lines, and waveforms when the total DC resistance value of the signal wiring 42 and the semiconductor film 50 is 30 Ω are indicated by solid lines. The simulation conditions of FIG. 10(a) are the same as those of paragraph 0028. The simulation conditions of FIG. 10(b) are the same as those of paragraph 0028 except that the average relative dielectric constant of air and the silicon substrate is 6.25, the length of the signal wiring 42 is 7 mm, and the resonance frequency is 8.33 GHz. The simulation conditions of FIG. 10(c) are the same as those of paragraph 0028 except that the average relative dielectric constant of air and the silicon substrate is 6.25, the length of the signal wiring 42 is 5 mm, and the resonance frequency is 11.67 GHz.

As illustrated in FIG. 10(a), in the case where the resonance frequency is 10 GHz when the total DC resistance value of the signal wiring 42 and the semiconductor film 50 is 0 Ω, the resonance frequency shifts to 12.3 GHz when the DC resistance value becomes 30 Q. As illustrated in FIG. 10(b), in the case where the resonance frequency is 9 GHz when the DC resistance value is 0 Ω, the resonance frequency shifts to 10.7 GHz when the DC resistance value becomes 30 Q. As illustrated in FIG. 10(c), in the case where the resonance frequency is 11 GHz when the DC resistance value is 0 Ω, the resonance frequency shifts to 14.4 GHz when the DC resistance value becomes 30 Ω. As described above, even when the resonance frequencies are different when the DC resistance value is 0 Ω, the resonance frequency when the DC resistance value is 30 Ω is higher than the resonance frequency when the DC resistance value is 0 Ω. From this, it is understood that, if the total DC resistance value of the signal wiring 42 and the semiconductor film 50 is known, it can be confirmed whether the resonance frequency at the DC resistance value of 0 Ω is shifted to a low frequency side or a high frequency side with respect to a desired frequency.

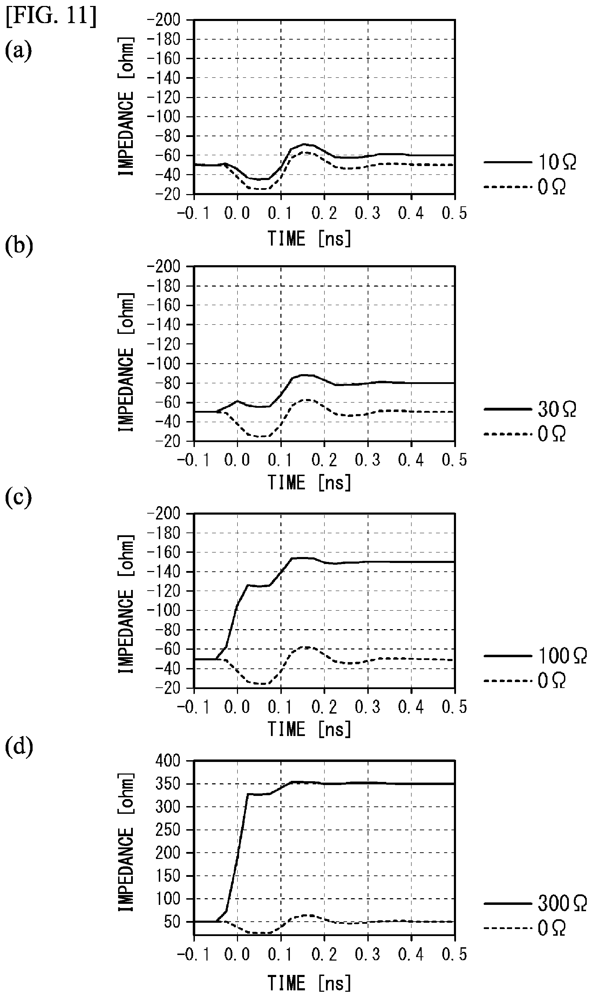

FIGs. 11(a) to 11(d) are diagrams illustrating simulation results of the TDR waveform of the signal wiring 42 in the first embodiment. In FIGs. 11(a) to 11(d), a horizontal axis represents time in ns units, and a vertical axis represents impedance in ohm units. In FIGs. 11(a) to 11(d), waveforms when the total DC resistance value of the signal wiring 42 and the semiconductor film 50 is 0 Ω are indicated by dotted lines, and waveforms when the total DC resistance value of the signal wiring 42 and the semiconductor film 50 is 10 Ω, 30 Ω, 100 Ω, and 300 Ω are indicated by solid lines. The simulation conditions of FIGs. 11(a) to 11(d) are the same as those of paragraph 0028. The TDR measurement is used to determine the level of the characteristic impedance at each position of the signal wiring 42. For example, the characteristic impedance decreases as the signal wiring 42 becomes thicker, and the characteristic impedance increases as the signal wiring 42 becomes thinner.

As illustrated in FIGs. 11(a) to 11(d), when the total DC resistance value of the signal wiring 42 and the semiconductor film 50 is 0 Ω, the impedance is low in the vicinity of 0.05 ns and high in the vicinity of 0.15 ns. In the case where the DC resistance value is 10 Ω or 30 Ω, the impedance is low in the vicinity of 0.05 ns and high in the vicinity of 0.15 ns, as in the case of 0 Q. However, in the case where the DC resistance value is 100 Ω or 300 Ω, it is not possible to determine whether the impedance is high or low. From this result, it is understood that in order to confirm the determination of the high and low of the impedance even in the TDR measurement, the total DC resistance value of the signal wiring 42 and the semiconductor film 50 is less than 100 Ω, and preferably 30 Ω or less.

From the above simulation results, the high frequency characteristic can be measured when the total DC resistance value of the signal wiring 42 and the semiconductor film 50 is less than 100 Ω, preferably 80 Ω or less, more preferably 50 Ω or less, and still more preferably 30 Ω or less. The DC resistance value of one semiconductor film 50 alone is preferably 30 Ω or less, more preferably 20 Ω or less, and still more preferably 10 Ω or less.

As described above, according to the first embodiment, as illustrated in FIGs. 1(a) to 2(b), the semiconductor film 50 having a width larger than the width of the signal wiring 42 is provided so as to overlap a part of the signal wiring 42 electrically connected to the quantum bit 20. As a result, as illustrated in FIGs. 5(a) to 6(b), the measurement terminal 82 is brought into contact with the semiconductor film 50, and the characteristic of the signal wiring 42 can be measured. Accordingly, as illustrated in FIG. 7, the characteristic of the signal wiring 42 can be measured without being affected by the quantum bit 20, and the characteristic of the signal wiring 42 can be measured under the temperature environment of the normal temperature. In general, the electrical resistance of a semiconductor increases as the temperature decreases. Therefore, even when the semiconductor film 50 is provided to overlap the signal wiring 42, the semiconductor film 50 has a large electric resistance and functions as an insulator at the cryogenic temperature of several tens milli-kelvin (mK) or less at which the quantum bit device 100 operates. Therefore, the influence on the characteristic of the quantum bit device 100 can be suppressed.

In addition, in the first embodiment, as illustrated in FIGs. 1(a) and 1(b), the semiconductor films 50 are provided so as to overlap both ends of the signal wiring 42. This makes it possible to measure the entire characteristic of the signal wiring 42. In the case of measuring the high frequency characteristic of the signal wiring 42, the measurement can be performed by bringing the measurement terminal 82 into contact with only one end of the signal wiring 42. In such a case, the semiconductor film 50 may be provided so as to overlap only one end of the signal wiring 42. Therefore, the semiconductor film 50 may be provided so as to overlap at least one of the two ends of the signal wiring 42.

In the first embodiment, as illustrated in FIGs. 1(a) and 1(b), the signal wiring 42 constitutes the resonator 40 electrically connected to the quantum bit 20. Accordingly, the characteristic of the resonator 40 can be measured by measuring the characteristic of the signal wiring 42.

In the first embodiment, as illustrated in FIGs. 2(a) and 2(b), the semiconductor film 50 is provided above the substrate 10 in contact with a part of the signal wiring 42. This makes it possible to make the semiconductor film 50 thinner as compared with a third embodiment described later, and thus to suppress the total DC resistance value of the signal wiring 42 and the semiconductor film 50 to a low value.

In the first embodiment, as illustrated in FIGs. 2(a) and 2(b), the ground layers 44 are provided on both sides of the signal wiring 42, and the insulating films 46 are provided from on the ground layers 44 to the gaps between the ground layers 44 and the signal wiring 42. The semiconductor film 50 is provided from on the signal wiring 42 to on the insulating films 46. This makes it easy to obtain the semiconductor film 50 having a sufficient size to be brought into contact with the measurement terminal 82. In order to secure a region in contact with the measurement terminal 82, the widths Y1 and Y2 of the semiconductor film 50 (see the widths Y1 and Y2 in FIG. 2(a)) are preferably 50 µm or more and 500 µm or less. In consideration of securing a contact region of the measurement terminal 82 and the influence of providing the semiconductor film 50 on other devices, the widths Y1 and Y2 of the semiconductor film 50 may be 80 µm or more and 300 µm or less, or 100 µm or more and 200 µm or less.

In the first embodiment, the semiconductor film 50 is formed of a semiconductor material having an insulating property at a temperature of 20 milli-kelvin (mK). Thus, the electric resistance of the semiconductor film 50 at the cryogenic temperature at which the quantum bit device 100 is operated is increased, and therefore, even when the semiconductor film 50 is provided, the influence on the characteristic of the quantum bit device 100 can be suppressed to be small. Here, the term "having an insulating property" means that the electrical resistivity is 10⁴ Ω·m or more. As such a semiconductor film 50, for example, a semiconductor film formed of amorphous silicon, indium oxide, titanium oxide, or zinc oxide can be given.

In the first embodiment, as illustrated in FIG. 1(a), the quantum bit 20 includes the Josephson junction element 26. Since the Josephson junction element 26 has a structure in which the insulating film 34 is provided between the superconductor films 30 and 32 as illustrated in FIG. 4(b), the DC resistance value is likely to be as high as several thousands Ω, for example. However, even in the case where such a quantum bit 20 is provided, in the first embodiment, the characteristic of the signal wiring 42 can be measured without being affected by the quantum bit 20 as illustrated in FIG. 7, and therefore the characteristic of the signal wiring 42 can be measured with high accuracy.

In the first embodiment, the semiconductor film 50 is not in contact with the quantum bit 20 but is provided away from the quantum bit 20. Although the quantum bit 20 is required to have a high Q value, the Q value of the quantum bit 20 is lowered when the semiconductor film 50 is in contact with the quantum bit 20. By providing the semiconductor film 50 away from the quantum bit 20, it is possible to suppress a decrease in the Q value of the quantum bit 20.

In the first embodiment, when the characteristic of the signal wiring 42 is measured by bringing the measurement terminal 82 into contact with the semiconductor film 50, the measurement may be performed while the semiconductor film 50 is exposed to light or while the substrate 10 is heated to, for example, about 50 °C. This can reduce the total DC resistance value of the signal wiring 42 and the semiconductor film 50.

### [Second Embodiment]

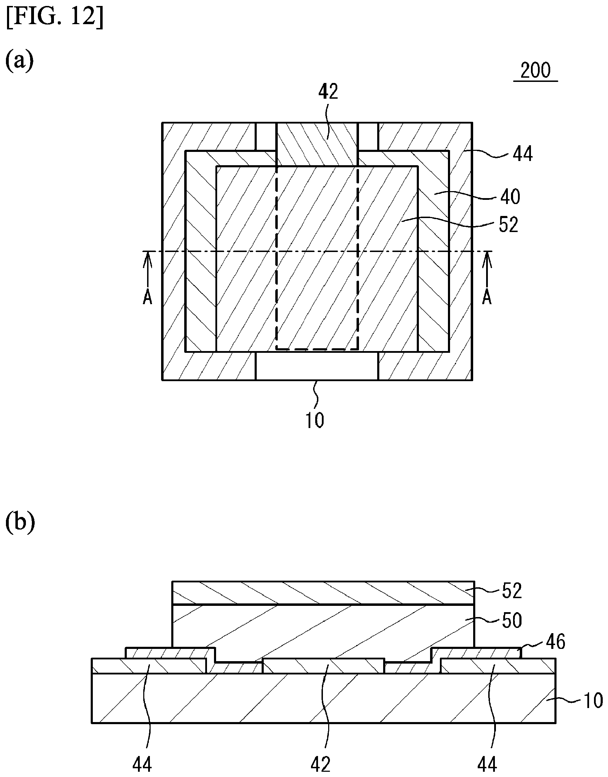

FIG. 12(a) is a plan view of a region in the vicinity of an end of the signal wiring 42 of a quantum bit device 200 according to a second embodiment, and FIG. 12(b) is a cross-sectional view taken along a line A-A in FIG. 12(a). As illustrated in FIGs. 12(a) and 12(b), in the second embodiment, a metal film 52 is provided in contact with and to cover the semiconductor film 50. The metal film 52 is a single layer film such as a copper film, an aluminum film, or a gold film, or a laminated film thereof. The other components are the same as those of the first embodiment, and therefore, the description thereof is omitted.

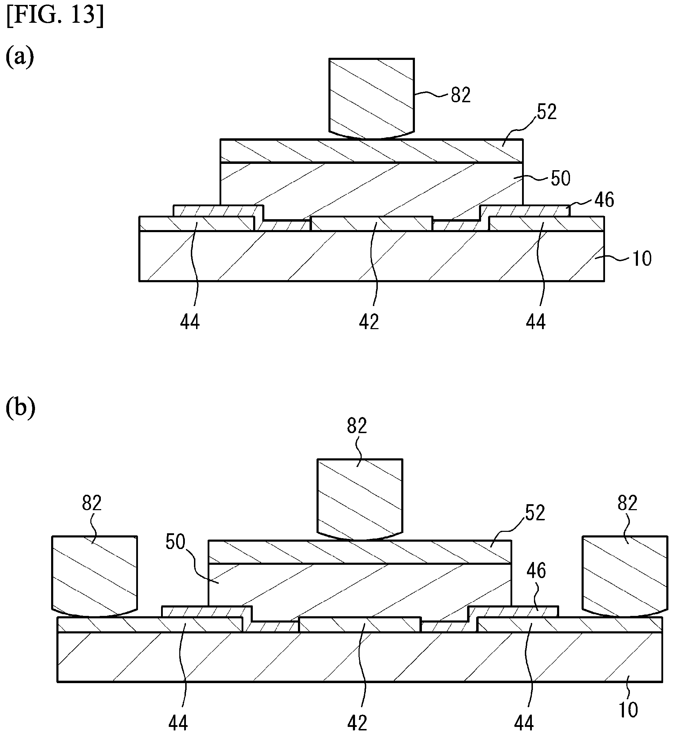

FIG. 13(a) is a cross-sectional view illustrating a method of measuring the DC resistance of the signal wiring 42 in the second embodiment, and FIG. 13(b) is a cross-sectional view illustrating a method of measuring the high frequency characteristic. As illustrated in FIGs. 13(a) and 13(b), in the second embodiment, the measurement terminal 82 is brought into contact with the metal film 52 to measure the characteristic of the signal wiring 42.

According to the second embodiment, the metal film 52 is provided in contact with and to overlap the semiconductor film 50. Thus, when the measurement terminal 82 is brought into contact with the semiconductor film 50 to measure the characteristic of the signal wiring 42, the current flows into the semiconductor film 50 while spreading in the in-plane direction of the metal film 52 because the measurement terminal 82 is in contact with the metal film 52. Therefore, in the case where the metal film 52 is provided, the DC resistance value of the current flowing between the measurement terminal 82 and the signal wiring 42 is smaller than the DC resistance value in the case where the metal film 52 is not provided.

### [Third Embodiment]

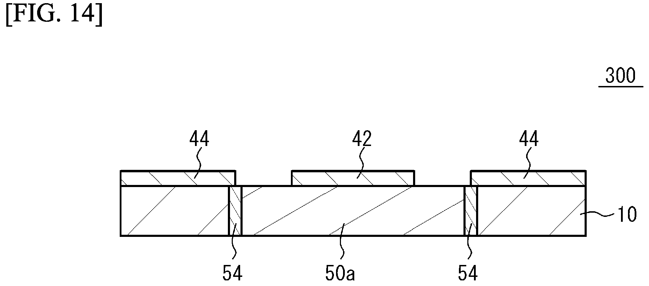

FIG. 14 is a cross-sectional view of a region in the vicinity of an end of the signal wiring 42 of a quantum bit device 300 according to a third embodiment. As illustrated in FIG. 14, in the third embodiment, the insulating film 46 and the semiconductor film 50 are not provided on the substrate 10, but a semiconductor film 50a is buried in the substrate 10. The upper surface of the semiconductor film 50a is exposed from the upper surface of the substrate 10 and is in contact with the signal wiring 42, and the lower surface thereof is exposed from the lower surface of the substrate 10. An insulating film 54 embedded in the substrate 10 is provided between the semiconductor film 50a, and the substrate 10 and the ground layer 44. The semiconductor film 50a has a rectangular shape in plan view and has a width larger than the width of the signal wiring 42, similarly to the semiconductor film 50. The other components are the same as those of the first embodiment, and therefore, the description thereof is omitted.

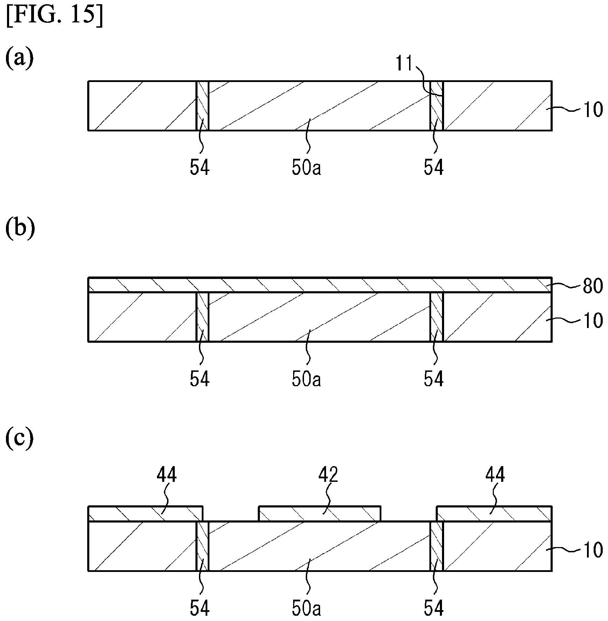

FIGs. 15(a) to 15(c) are cross-sectional views illustrating a method of manufacturing the quantum bit device 300 according to the third embodiment. As illustrated in FIG. 15(a), after a through hole 11 is formed in the substrate 10, the insulating film 54 and the semiconductor film 50a are buried in the through hole 11. The through hole 11 is formed by, for example, etching or laser processing. The insulating film 54 and the semiconductor film 50a are formed by, for example, forming a film by the vapor deposition method or the CVD method and then removing an unnecessary portion formed on the upper surface of the substrate 10 by polishing or the like.

As illustrated in FIG. 15(b), the superconductor film 80 is formed on the substrate 10 by, for example, the sputtering method or the vapor deposition method.

As illustrated in FIG. 15(c), the superconductor film 80 is patterned by using, for example, the photolithography method and the etching method. Thus, the signal wiring 42 and the ground layer 44 constituting the resonator 40 are formed. The semiconductor films 50a are in contact with and overlap both ends of the signal wiring 42. Although not illustrated, the central electrode 22, the outer peripheral electrode 24, the coupling wiring 60, and the read terminal 62 are also formed. Thereafter, the Josephson junction element 26 is formed by the same method as that of FIGs. 4(a) and 4(b) of the first embodiment.

The measurement of the characteristic of the signal wiring 42 in the third embodiment is performed by bringing the measurement terminal 82 into contact with the semiconductor film 50a from the lower surface side of the substrate 10.

According to the third embodiment, the semiconductor film 50a having the width larger than the width of the signal wiring 42 is provided so as to overlap a part of the signal wiring 42. As a result, as in the first embodiment, the characteristic of the signal wiring 42 can be measured without being affected by the quantum bit 20, and the characteristic of the signal wiring 42 can be measured under the temperature environment of the normal temperature.

In the third embodiment, the semiconductor film 50a is buried in the substrate 10 and is provided in contact with a part of the signal wiring 42. Thus, the characteristic of the signal wiring 42 can be measured by bringing the measurement terminal 82 into contact with the semiconductor film 50 from the lower surface side of the substrate 10.

### [Fourth Embodiment]

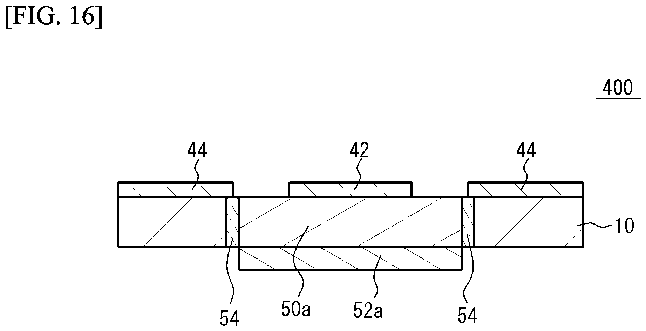

FIG. 16 is a cross-sectional view of a region in the vicinity of an end of the signal wiring 42 of a quantum bit device 400 according to a fourth embodiment. As illustrated in FIG. 16, in the fourth embodiment, the semiconductor film 50a in contact with the signal wiring 42 and the insulating film 54 for electrically isolating the semiconductor film 50a from the substrate 10 and the ground layer 44 are embedded in the substrate 10, as in the third embodiment. Unlike the third embodiment, a metal film 52a is provided on the surface of the semiconductor film 50a opposite to the signal wiring 42 and to overlap the semiconductor film 50a. The other components are the same as those of the first embodiment, and therefore, the description thereof is omitted.

The measurement of the characteristic of the signal wiring 42 in the fourth embodiment is performed by bringing the measurement terminal 82 into contact with the metal film 52a from the lower surface side of the substrate 10.

According to the fourth embodiment, the metal film 52a is provided in contact with and to overlap the semiconductor film 50a. Thus, in the case where the measurement terminal 82 is brought into contact with the semiconductor film 50a to measure the characteristic of the signal wiring 42, the current flows into the semiconductor film 50a while spreading in the in-plane direction of the metal film 52a because the measurement terminal 82 is in contact with the metal film 52a, as in the second embodiment. Therefore, the DC resistance value of the current flowing between the measurement terminal 82 and the signal wiring 42 is reduced.

### [Fifth Embodiment]

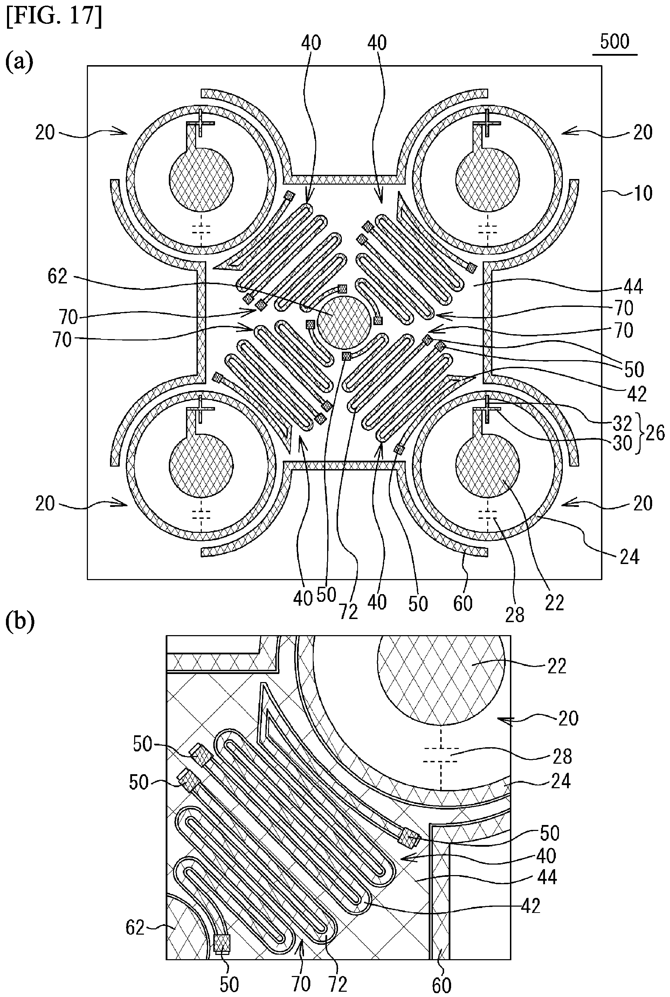

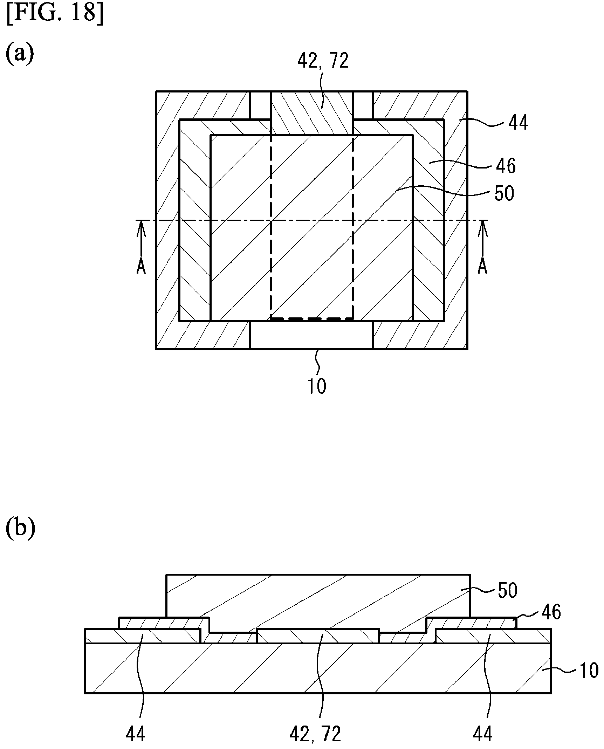

FIG. 17(a) is a plan view of a quantum bit device 500 according to a fifth embodiment, and FIG. 17(b) is an enlarged plan view of a region in the vicinity of the resonator 40 and a bandpass filter 70. In FIGs. 17(a) and 17(b), the superconductor film and the semiconductor film provided on the substrate 10 are hatched for the sake of clarity of the drawings. For the sake of clarity of the drawings, the ground layer 44 illustrated in FIG. 17(b) is omitted in FIG. 17(a), and the insulating film 46 illustrated in FIGs. 18(a) and 18(b) is omitted in FIGs. 17(a) and 17(b).

As illustrated in FIGs. 17(a) and 17(b), in the fifth embodiment, a plurality of bandpass filters 70 are provided on the substrate 10 in addition to the plurality of quantum bits 20, the plurality of resonators 40, the plurality of coupling wirings 60, and the read terminal 62. The plurality of bandpass filters 70 are electrostatically coupled to the plurality of resonators 40, respectively. The plurality of bandpass filters 70 are electrostatically coupled to the single read terminal 62. In this way, the bandpass filters 70 are connected between the resonators 40 and the read terminal 62. The connection between the resonator 40 and the bandpass filter 70 and the connection between the bandpass filter 70 and the read terminal 62 are connection at high frequency.

The bandpass filter 70 includes a coplanar line having a meander structure in which the signal wiring 72 is interposed between the ground layers 44, as in the resonator 40. A high frequency signal for reading in, for example, a gigahertz band (for example, 2 GHz to 10 GHz) is propagated to the signal wiring 72. The signal wiring 72 is formed of a superconducting material, such as aluminum (Al), titanium nitride (TiN), niobium (Nb), or tantalum (Ta), as in the case of the signal wiring 42. The semiconductor films 50 are provided on both ends of the signal wiring 72 of the bandpass filter 70 in addition to both ends of the signal wiring 42 of the resonator 40. The semiconductor films 50 are not provided at a portion of the signal wiring 42 other than both ends thereof and a portion of the signal wiring 72 other than both ends thereof. The other components are the same as those of the first embodiment, and therefore, the description thereof is omitted.

FIG. 18(a) is a plan view of a region in the vicinity of ends of the signal wirings 42 and 72 of the quantum bit device 500 according to the fifth embodiment, and FIG. 18(b) is a cross-sectional view taken along a line A-A in FIG. 18(a). As illustrated in FIGs. 18(a) and 18(b), the semiconductor film 50 has a width larger than the width of the signal wirings 42 and 72 and is provided to cover the entire portion in the width direction of the signal wirings 42 and 72. The width of the signal wiring 72 is substantially equal to the width of the signal wiring 42, and is, for example, 10 µm to 30 µm. The insulating film 46 is provided to cover from on the ground layer 44 to the gap between the signal wirings 42 and 72 and the ground layer 44 while exposing the upper surfaces of the signal wirings 42 and 72 without covering them. The semiconductor film 50 is in contact with the upper surfaces of the signal wirings 42 and 72, and is provided from on the signal wirings 42 and 72 to on the insulating film 46.

According to the fifth embodiment, the semiconductor film 50 having a width larger than the width of the signal wirings 42 and 72 is provided so as to overlap a part of the signal wirings 42 and 72. This allows the measurement terminal 82 to be brought into contact with the semiconductor film 50 to measure the characteristics of the signal wirings 42 and 72. Therefore, the characteristics of the signal wirings 42 and 72 can be measured without being affected by the quantum bit 20, and the characteristics of the signal wirings 42 and 72 can be measured under the temperature environment of the normal temperature.

In the fifth embodiment, the signal wiring 42 constitutes the resonator 40 electrically connected to the quantum bit 20, and the signal wiring 72 constitutes the bandpass filter 70 electrically connected to the quantum bit 20. Accordingly, the characteristics of the resonator 40 and the bandpass filter 70 can be measured by measuring the characteristics of the signal wirings 42 and 72.

Although the semiconductor film 50 is provided above the substrate 10 and is in contact with the end of the signal wiring 72 in the fifth embodiment, the semiconductor film 50a may be embedded in the substrate 10 and be in contact with the end of the signal wiring 72, as in the third embodiment. In this case, as in the fourth embodiment, the metal film 52a may be provided so as to overlap the semiconductor film 50a.

Although the embodiments of the present disclosure have been described in detail, the present disclosure is not limited to the specific embodiments, but various variations and changes are possible within the scope of the present invention as described in the claims.

### [Reference Signs List]

- 10: substrate
- 20: quantum bit
- 22: central electrode
- 24: outer peripheral electrode
- 26: Josephson junction element
- 28: capacitor
- 30, 32: superconductor film
- 34: insulating film
- 40: resonator
- 42: signal wiring
- 44: ground layer
- 46: insulating film
- 50, 50a: semiconductor film
- 52, 52a: metal film
- 54: insulating film
- 60: coupling wiring
- 62: read terminal
- 70: bandpass filter
- 72: signal wiring
- 80: superconductor film
- 82: measurement terminal
- 100, 200, 300, 400, 500: quantum bit device

## Claims

1. A quantum bit device (100, 200, 300, 400, 500) comprising:
a substrate (10);
a quantum bit (20) provided on the substrate;
a signal wiring (42) provided on the substrate and electrically connected to the quantum bit; **characterized by**
a semiconductor film (50) provided to overlap a part of the signal wiring, the semiconductor film having a width larger than a width of the signal wiring.

2. The quantum bit device according to claim 1, wherein
the part of the signal wiring is at least one end of both ends of the signal wiring.

3. The quantum bit device according to claim 1 or 2, further comprising
a metal film (52) configured to be in contact with and overlap the semiconductor film.

4. The quantum bit device according to claim 1 or 2, wherein
the signal wiring includes a resonator (40) or a bandpass filter (70) electrically coupled to the quantum bit.

5. The quantum bit device according to claim 1 or 2, wherein
the semiconductor film is provided above the substrate and is in contact with the part of the signal wiring.

6. The quantum bit device according to claim 5, further comprising:
a ground layer (44) provided on both sides of the signal wiring on the substrate; and
an insulating film (46) provided from on the ground layer to a gap between the ground layer and the signal wiring;
wherein the semiconductor film is provided from on the signal wiring to on the insulating film.

7. The quantum bit device according to claim 1 or 2, wherein
the semiconductor film is embedded in the substrate and provided in contact with the part of the signal wiring.

8. The quantum bit device according to claim 1 or 2, wherein
the semiconductor film is formed of a semiconductor material having an insulating property at a temperature of 20 milli-kelvins.

9. The quantum bit device according to claim 1 or 2, wherein
the semiconductor film is formed of amorphous silicon, indium oxide, titanium dioxide, zinc dioxide, gallium arsenide, indium phosphide, cadmium telluride, or cadmium sulfide.

10. The quantum bit device according to claim 1 or 2, wherein
the quantum bit includes a Josephson junction element.

11. The quantum bit device according to claim 1 or 2, wherein
the signal wiring is formed of a superconducting material.

12. The quantum bit device according to claim 1 or 2, wherein
the semiconductor film has a length of 50 µm or more and 500 µm or less in each of a width direction of the signal wiring and a direction orthogonal to the width direction in plan view.

13. A method of manufacturing a quantum bit device, comprising:
forming a signal wiring on a substrate;
forming a semiconductor film having a width larger than a width of the signal wiring, the semiconductor film overlapping a part of the signal wiring; and
forming a quantum bit electrically connected to the signal wiring on the substrate.

14. A method of measuring a quantum bit device, the quantum bit device including a quantum bit and a signal wiring electrically connected to the quantum bit on a substrate, and including a semiconductor film having a width larger than a width of the signal wiring, the semiconductor film overlapping a part of the signal wiring, the method comprising:
bringing a measurement terminal into contact with the semiconductor film; and
measuring a characteristic of the signal wiring.

15. The method of measuring the quantum bit device according to claim 14, wherein
at least one of a direct current resistance, a resonance waveform, and a time domain reflectometry (TDR) is measured as the characteristic of the signal wiring.

## Patentansprüche

1. Quantenbitvorrichtung (100, 200, 300, 400, 500), umfassend:
ein Substrat (10);
ein Quantenbit (20), das auf dem Substrat bereitgestellt ist;
eine Signalverdrahtung (42), die auf dem Substrat bereitgestellt ist und mit dem Quantenbit elektrisch verbunden ist; **gekennzeichnet durch**
eine Halbleiterfolie (50), die so bereitgestellt ist, dass sie einen Teil der Signalverdrahtung überlappt, wobei die Halbleiterfolie eine Breite aufweist, die größer ist als eine Breite der Signalverdrahtung.

2. Quantenbitvorrichtung nach Anspruch 1, wobei
ein Teil der Signalverdrahtung mindestens ein Ende von beiden Enden der Signalverdrahtung ist.

3. Quantenbitvorrichtung nach Anspruch 1 oder 2, weiter umfassend
eine Metallfolie (52), die so ausgebildet ist, dass sie mit der Halbleiterfolie in Kontakt steht und diese überlappt.

4. Quantenbitvorrichtung nach Anspruch 1 oder 2, wobei
die Signalverdrahtung einen Resonator (40) oder einen Bandpassfilter (70) einschließt, der mit dem Quantenbit elektrisch gekoppelt ist.

5. Quantenbitvorrichtung nach Anspruch 1 oder 2, wobei
die Halbleiterfolie über dem Substrat bereitgestellt ist und mit dem Teil der Signalverdrahtung in Kontakt steht.

6. Quantenbitvorrichtung nach Anspruch 5, weiter umfassend:
eine Erdungsschicht (44), die an beiden Seiten der Signalverdrahtung auf dem Substrat bereitgestellt ist; und
eine Isolierschicht (46), die von der Erdungsschicht zu einem Spalt zwischen der Erdungsschicht und der Signalverdrahtung bereitgestellt ist;
wobei die Halbleiterfolie von auf der Signalverdrahtung bis auf die Isolierschicht bereitgestellt ist.

7. Quantenbitvorrichtung nach Anspruch 1 oder 2, wobei
die Halbleiterfolie in das Substrat eingebettet ist und in Kontakt mit dem Teil der Signalverdrahtung bereitgestellt ist.

8. Quantenbitvorrichtung nach Anspruch 1 oder 2, wobei
die Halbleiterfolie aus einem Halbleitermaterial gebildet ist, das bei einer Temperatur von 20 Millikelvin eine Isoliereigenschaft aufweist.

9. Quantenbitvorrichtung nach Anspruch 1 oder 2, wobei
die Halbleiterfolie aus amorphem Silizium, Indiumoxid, Titandioxid, Zinkdioxid, Galliumarsenid, Indiumphosphid, Kadmiumtellurid oder Cadmiumsulfid gebildet ist.

10. Quantenbitvorrichtung nach Anspruch 1 oder 2, wobei
das Quantenbit ein Josephson-Übergangelement einschließt.

11. Quantenbitvorrichtung nach Anspruch 1 oder 2, wobei
die Signalverdrahtung aus einem supraleitenden Material gebildet ist.

12. Quantenbitvorrichtung nach Anspruch 1 oder 2, wobei
die Halbleiterfolie in Draufsicht in jeder einer Breitenrichtung der Signalverdrahtung und einer Richtung orthogonal zu der Breitenrichtung eine Länge von 50 µm oder mehr und 500 µm oder weniger aufweist.

13. Verfahren zum Herstellen einer Quantenbitvorrichtung, umfassend:
Bilden einer Signalverdrahtung auf einem Substrat;
Bilden einer Halbleiterfolie, die eine Breite aufweist, die größer ist als eine Breite der Signalverdrahtung, wobei die Halbleiterfolie einen Teil der Signalverdrahtung überlappt; und
Bilden eines Quantenbits, das mit der Signalverdrahtung auf dem Substrat elektrisch verbunden ist.

14. Verfahren zum Messen einer Quantenbitvorrichtung, wobei die Quantenbitvorrichtung ein Quantenbit und eine mit dem Quantenbit auf einem Substrat elektrisch verbundene Signalverdrahtung einschließt und eine Halbleiterfolie einschließt, die eine Breite aufweist, die größer ist als eine Breite der Signalverdrahtung, wobei die Halbleiterfolie einen Teil der Signalverdrahtung überlappt, wobei das Verfahren Folgendes umfasst:
Inkontaktbringen eines Messanschlusses mit der Halbleiterfolie; und
Messen eines Merkmals der Signalverdrahtung.

15. Verfahren zum Messen der Quantenbitvorrichtung nach Anspruch 14, wobei
mindestens eines von einem Gleichstromwiderstands, einer Resonanzwellenform und einer Zeitbereichsreflektometrie (TDR) als das Merkmal der Signalverdrahtung gemessen wird.

## Revendications

1. Dispositif (100, 200, 300, 400, 500) de bit quantique comprenant :
un substrat (10) ;
un bit quantique (20) prévu sur le substrat ;
un câblage (42) de signal prévu sur le substrat et connecté électriquement au bit quantique ; **caractérisé par**
un film semi-conducteur (50) prévu de manière à chevaucher une partie du câblage de signal, le film semi-conducteur présentant une largeur supérieure à une largeur du câblage de signal.

2. Dispositif de bit quantique selon la revendication 1, dans lequel
la partie du câblage de signal est au moins une extrémité parmi les deux extrémités du câblage de signal.

3. Dispositif de bit quantique selon la revendication 1 ou la revendication 2, comprenant en outre
un film métallique (52) configuré pour venir en contact avec et chevaucher le film semi-conducteur.

4. Dispositif de bit quantique selon la revendication 1 ou la revendication 2, dans lequel
le câblage de signal inclut un résonateur (40) ou un filtre passe-bande (70) couplé électriquement au bit quantique.

5. Dispositif de bit quantique selon la revendication 1 ou la revendication 2, dans lequel
le film semi-conducteur est prévu au-dessus du substrat et est en contact avec la partie du câblage de signal.

6. Dispositif de bit quantique selon la revendication 5, comprenant en outre :
une couche de masse (44) prévue sur les deux côtés du câblage de signal sur le substrat ;
et
un film isolant (46) prévu depuis la couche de masse jusqu'à un espace entre la couche de masse et le câblage de signal ;
dans lequel le film semi-conducteur est prévu du câblage de signal jusqu'au film isolant.

7. Dispositif de bit quantique selon la revendication 1 ou la revendication 2, dans lequel
le film semi-conducteur est intégré dans le substrat et prévu en contact avec la partie du câblage de signal.

8. Dispositif de bit quantique selon la revendication 1 ou la revendication 2, dans lequel
le film semi-conducteur est formé d'un matériau semi-conducteur présentant une propriété isolante à une température de 20 millikelvins.

9. Dispositif de bit quantique selon la revendication 1 ou la revendication 2, dans lequel
le film semi-conducteur est formé de silicium amorphe, d'oxyde d'indium, de dioxyde de titane, de dioxyde de zinc, d'arséniure de gallium, de phosphure d'indium, de tellurure de cadmium ou de sulfure de cadmium.

10. Dispositif de bit quantique selon la revendication 1 ou la revendication 2, dans lequel
le bit quantique inclut un élément de jonction Josephson.

11. Dispositif de bit quantique selon la revendication 1 ou la revendication 2, dans lequel
le câblage de signal est formé d'un matériau supraconducteur.

12. Dispositif de bit quantique selon la revendication 1 ou la revendication 2, dans lequel
le film semi-conducteur présente une longueur de 50 µm ou plus et de 500 µm ou moins dans chacune d'une direction de la largeur du câblage de signal et d'une direction orthogonale à la direction de la largeur en vue en plan.

13. Procédé de fabrication d'un dispositif de bit quantique, comprenant :
la formation d'un câblage de signal sur un substrat ;
la formation d'un film semi-conducteur présentant une largeur supérieure à une largeur du câblage de signal, le film semi-conducteur chevauchant une partie du câblage de signal ; et
la formation d'un bit quantique connecté électriquement au câblage de signal sur le substrat.

14. Procédé de mesure d'un dispositif de bit quantique, le dispositif de bit quantique incluant un bit quantique et un câblage de signal connecté électriquement au bit quantique sur un substrat, et incluant un film semi-conducteur présentant une largeur supérieure à une largeur du câblage de signal, le film semi-conducteur chevauchant une partie du câblage de signal, le procédé comprenant :
le fait d'amener une borne de mesure en contact avec le film semi-conducteur ; et
la mesure d'une caractéristique du câblage de signal.

15. Procédé de mesure du dispositif de bit quantique selon la revendication 14, dans lequel
au moins une d'une résistance en courant continu, d'une forme d'onde de résonance et d'une réflectométrie dans le domaine temporel (TDR) est mesurée en tant que caractéristique du câblage de signal.
